# EUROPEAN PATENT SPECIFICATION

(11) **EP 3 805 129 B1**
(45) Date of publication and mention of the grant of the patent: **15.01.2025**
(21) Application number: 19807613.5
(22) Date of filing: 23.05.2019
(51) Int. Cl.: B65D 85/86, H05K 13/02, H05K 13/04, H05K 13/00

(54) **ELECTRONIC COMPONENT SUPPLY BODY, AND ELECTRONIC COMPONENT SUPPLY REEL**
ZUFÜHRKÖRPER FÜR ELEKTRONISCHE BAUTEILE UND ZUFÜHRSPULE FÜR ELEKTRONISCHE BAUTEILE
CORPS D'ALIMENTATION EN COMPOSANTS ÉLECTRONIQUES ET BOBINE DÉBITRICE DE COMPOSANTS ÉLECTRONIQUES

(30) Priority: 25.05.2018 JP 2018100947
(43) Date of publication of application: 14.04.2021
(73) Proprietor: Dexerials Corporation, Tokyo 141-0032 (JP)
(72) Inventor: TAKAMATSU, Hiroshi, Tokyo 141-0032 (JP); KUROSAKI, Tomoyuki, Tokyo 141-0032 (JP); HIYAMA, Teruo, Tokyo 141-0032 (JP)
(74) Representative: Müller-Boré & Partner Patentanwälte PartG mbB
(86) International application number: PCT/JP2019/020400
(87) International publication number: WO 2019/225684

(56) References cited:
- JP-A- 2005 035 636
- JP-A- 2014 025 047
- JP-A- 2014 532 602
- JP-A- 2015 164 157
- US-A1- 2006 157 382
- US-A1- 2007 216 000
- US-A1- 2015 108 038
- US-A1- 2017 072 659

## Description

### TECHNICAL FIELD

This technology relates to an electronic component supply body using an embossed carrier tape for accommodating various components.

### TECHNICAL FIELD

Conventionally, in a semiconductor element mounted in various electronic devices such as a personal computer and other devices, various cooling means are employed because accumulation of the heat generated during driving affects the operation of semiconductors elements and peripheral devices. As a method of cooling electronic components such as a semiconductor element, there is known a method of mounting a fan on the device to cool air in the device housing or a method of mounting a heat sink such as a heat radiating fin or a heat radiating plate on the semiconductor element to be cooled.

When a heat sink is attached to a semiconductor element to perform cooling, a thermally conductive sheet is provided between the semiconductor element and the heat sink in order to efficiently discharge heat of the semiconductor element. As the thermally conductive sheet, a silicone resin containing a filler such as a heat conductive filler dispersed therein is widely used, and a carbon fiber is used as one of the heat conductive fillers (see, for example, Patent Document 1). Patent Document 2 discloses an electronic component package tape comprising a carrier tape of belt-like form storing electronic components in storage pockets formed into a concaved box shape at predetermined pitches, a cover tape of ribbon-like form bonded to the carrier tape to seal upper openings of the storage pockets, and first protrusions, each having a tip of rounded surface formed on an underside surface of the cover tape facing the electronic components.

### PRIOR ART REFERENCE

### PATENT REFERENCE

Patent Document 1: Japanese Patent No.5671266
Patent Document 2: US 2006/157382 A1

### SUMMARY OF THE INVENTION

### PROBLEM TO BE SOLVED BY THE INVENTION

As a member for supplying the thermally conductive sheet, there is known an electronic component supply body in the form of a tape having accommodating recess for accommodating an electronic component such as the thermally conductive sheet. The electronic component supply body comprises an embossed carrier tape formed in a long shape and having a plurality of accommodating recesses formed in the longitudinal direction, and a cover film formed in a long shape and laminated on the embossed carrier tape to seal the accommodating recesses.

The bottom surface of the accommodating recess is formed with a plurality of concave-convex portion in order to bringing the electronic component and the bottom surface of the accommodating recess into point contact, thereby improving the taking-out property which would be degraded when the electronic component and the bottom surface of the accommodating recess are in close contact.

Such an electronic component supply body accommodates electronic components in the accommodating recesses, is sealed with a cover film, and is supplied as a reel body wound in a reel shape. In use, the electronic component supply body is drawn out from the reel body, the cover film is peeled off, and then the electronic component is mounted by hand or automatically by a pickup mechanism such as a vacuum nozzle.

Here, when the electronic component supply body is wound in a reel shape, the winding pressure accumulates in accordance with the amount of winding and is applied at a portion close to the winding core, so that the electronic component in the accommodating recess tends to be in close contact with concave portions, side walls, or the cover film in addition to the convex portions of the bottom surface of the accommodating recess. Therefore, when an electronic component having flexibility and tackiness (slight adhesiveness) such as a thermally conductive sheet is accommodated, there is a possibility that, when the cover film is peeled off, the electronic component adhered to the cover film is also removed or that the electronic component cannot be picked up by a vacuum nozzle, thereby degrading working efficiency.

If the suction force of the vacuum nozzle is increased, the shape of the thin and flexible thermally conductive sheet cannot be maintained, thereby making the mounting difficult. In addition, if the tackiness of the thermally conductive sheet is reduced in order to improve the taking-out property from the accommodating recess, there is a possibility that the close contact to the semiconductor element or the heat sink is deteriorated and the positional deviation is induced, so that the thermal conductivity is lowered.

Therefore, there is a need for a method for improving the taking-out property for taking out an electronic component such as a thermally conductive sheet having flexibility and tackiness from the accommodating recess.

In view of the foregoing, it is an object of the present technology to provide an electronic component supply body and an electronic component supply reel, which can improve taking-out property of an electronic component having flexibility and tackiness.

### MEANS OF SOLVING THE PROBLEM

In order to solve the above problem, an electronic component supply body according to the present technology includes: an embossed carrier tape which is formed in a long shape and has a plurality of accommodating recesses on the surface thereof respectively accommodating one electronic component; and a cover film which is formed in a long shape and is laminated on the surface of the embossed carrier tape to seal the accommodating recess, characterized in that a pasting surface of the cover film to be pasted to the embossed carrier tape is formed with a concave-convex portion on which a plurality of protrusions are formed such that variations in the peeling force generated when the cover film is peeled are suppressed, wherein the protrusions are formed by piercing the cover film with a needle to form a through hole so that the periphery of the through hole through which the needle tip penetrates protrudes in a convex shape, and wherein a plurality of the through holes are formed uniformly over the entire surface of the cover film.

In addition, an electronic component supply reel according to the present technology includes: an electronic component supply body which is formed in a long shape; and a reel member around which the electronic component supply body is wound as defined in the appended claims.

### EFFECTS OF THE INVENTION

According to the present technology, since the concave-convex portion is formed on the pasting surface of the cover film, even when the electronic component comes into contact with the cover film, the electronic component can be prevented from being taken out when the cover film is peeled off due to the close contact between the cover film and the electronic component.

In addition, according to the present technology, by forming the concave-convex portion on the pasting surface of the cover film, it is possible to suppress variations in the peeling force (sealing strength) generated when the cover film is peeled, to smoothly peel off the cover film, to reduce an impact to the accommodating recess, to suppress the displacement and the protrusion of the electronic component, and to improve the taking-out property in the subsequent pickup process.

### BRIEF DESCRIPTION OF THE DRAWINGS

FIG. 1A is a plan view of an electronic component supply body, FIG. 1B is an X-X cross-sectional view, and FIG. 1C is a Y-Y cross-sectional view.
FIG. 2 is an external perspective view of an electronic component supply reel.
FIG. 3A is a cross-sectional view showing an example of a process of forming a protrusion on the cover film and FIG. 3B is a top view showing a concave-convex portion.
FIG. 4 is a view showing a process of passing the cover film supported on a base film through a rotary embossing machine.
FIG. 5 is a schematic view showing an example of a flow of a method for manufacturing a thermally conductive sheet.
FIG. 6 is a cross-sectional view showing a thermally conductive sheet, a heat radiation member, and a semiconductor device.
FIG. 7 is a graph showing the peeling strength (N) with respect to the peeling length of a cover film of an electronic component supply body according to an example.
FIG. 8 is a graph showing the peeling strength (N) with respect to the peeling length of a cover film of the electronic component supply body according to a comparative example.

### MODE FOR CARRYING OUT THE INVENTION

Hereinafter, the embossed carrier tape and the embossed carrier tape wound body according to the present technology will be described in detail with reference to the drawings. It should be noted that the present technology is not limited to the following embodiments and various modifications can be made without departing from the scope of the present technology. Moreover, the features illustrated in the drawings are shown schematically and are not intended to be drawn to scale. Actual dimensions should be determined in consideration of the following description. Furthermore, those skilled in the art will appreciate that dimensional relations and proportions may be different among the drawings in certain parts.

### Electronic component supply body

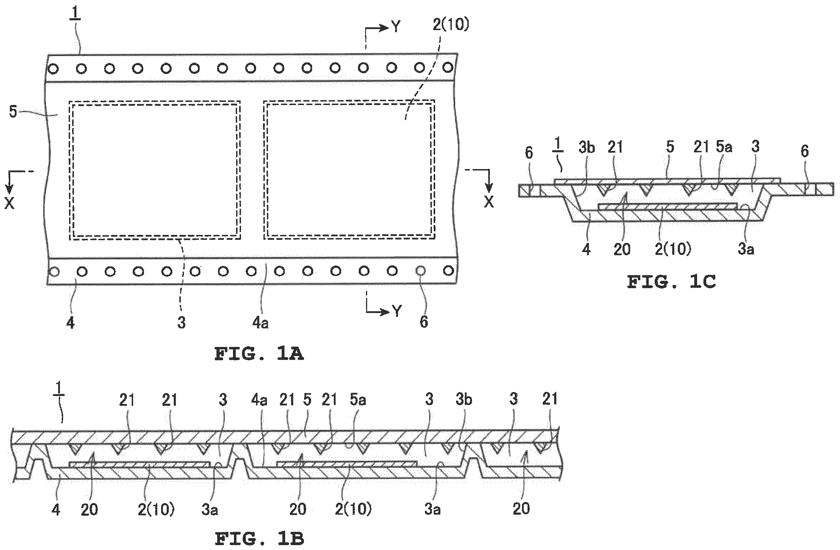

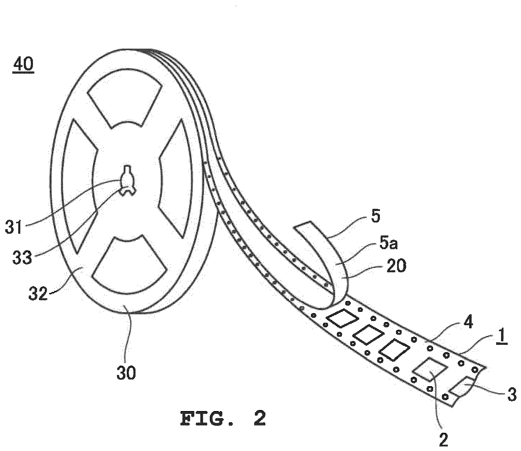

As shown in FIGs. 1 and 2, an electronic component supply body 1 according to the present technology includes: an embossed carrier tape 4 which is formed in a long shape and has a plurality of accommodating recesses 3 on its surface respectively accommodating one electronic component 2; and a cover film 5 which is formed in a long shape and is laminated on the surface of the embossed carrier tape 4 to seal the accommodating recesses 3. Hereinafter, a description will be given of an example in which a thermally conductive sheet 10 is used as the electronic component 2 to be accommodated in the accommodating recess 3 and supplied.

### Embossed carrier tape

As shown in FIG. 1, the embossed carrier tape 4 is formed in a long strip shape with a plurality of accommodating recesses 3 and a plurality of feed holes (perforations) 6 in the surface 4a in the longitudinal direction. The accommodating recesses 3 and the feed holes 6 are arranged at equal intervals in the longitudinal direction of the embossed carrier tape 4. The space between the accommodating recesses 3 can be appropriately set, and is, for example, 0.3 to 2.5 mm.

The embossed carrier tape 4 can have a length of several tens meters to several hundred meters, and several thousand heat-conductive sheets of several tens mm square can be accommodated. Although any known plastic material can be used as the material of the embossed carrier tape 4, PET or polycarbonate can be suitably used from the viewpoint of heat resistance and weather resistance, for example.

The accommodating recess 3 is formed in a shape corresponding to the shape of the electronic component to be accommodated, and when, for example, a rectangular thermally conductive sheet 10 is accommodated, the accommodating recess 3 is formed in a suitable longitudinal length, lateral length, and depth for accommodating the thermally conductive sheet 10. Specifically, the longitudinal and lateral lengths of the accommodating recess 3 are slightly larger than the longitudinal and lateral lengths of the thermally conductive sheet 10 (for example, a size about 0.05 to 0.2 mm larger than the longitudinal and lateral lengths of the thermally conductive sheet 10).

Further, the depth of the accommodating recess 3 is configured to be slightly larger (for example, about 0.05 to 0.3 mm larger) than the thickness of the thermally conductive sheet 10. Configuring the accommodating recess 3 in such a size eliminates a possibility that the thermally conductive sheet 10 protrudes from the accommodating recess 3 during the process of accommodating the thermally conductive sheet 10 and sealing it with the cover film 5. In addition, this reduce the possibility that the thermally conductive sheet 10 is caught by the accommodating recess 3 when the thermally conductive sheet 10 is sucked by the vacuum nozzle and taken out, and the thermally conductive sheet 10 is not shifted in the accommodating recess 3 even when wound in a reel shape, so that the thermally conductive sheet 10 can be sucked correctly.

It should be noted that the accommodating recess 3 may be a concave-convex surface formed with a plurality of protrusions in the bottom surface 3a. In this case, a silicone resin layer may be formed on the bottom surface 3a of the accommodating recess 3 excluding the plurality of protrusions, the portion of the plurality of protrusions excluding the top portion, and the side surface 3b. The silicone resin layer can be formed by coating the embossed carrier tape 4 with the silicone resin in a state where the accommodating recess 3 is molded and the protrusion top is masked.

### Cover film

The cover film 5 is pasted to the surface 4a of the embossed carrier tape 4 to seal the accommodating recess 3 in which the thermally conductive sheet 10 is accommodated, and is formed to have a width substantially equal to or slightly narrower than that of the embossed carrier tape 4, and is formed in a long shape so as to be laminated in the longitudinal direction of the embossed carrier tape 4. Although any known plastic material can be used as the material of the cover film 5, a PET film or a polyester film can be suitably used from the viewpoint of heat resistance and weather resistance, for example.

As a bonding method of the cover film 5 and the embossed carrier tape 4, a bonding method by heat sealing is suitable. Alternatively, an adhesive may be applied to the side edge of the cover film 5 in the longitudinal direction and bonded to the adhesive margin of the side edge of the embossed carrier tape 5. Alternatively, the cover film 5 and the embossed carrier tape 5 having the side edges coated with an adhesive in the longitudinal direction may be thermally bonded to each other in the longitudinal direction.

### Bonding strength

The bonding strength is appropriately set considering that the pressure applied when the electronic component supply body 1 is wound in the form of a reel, particularly the winding pressure in the portion near the winding core accumulates and increases in accordance with the amount of winding, and that the electronic component supply body 1 should endure vibration, heat, and thermal shock when transporting the reel body and should be stable over time. If the bonding strength is too weak, the cover film 5 is peeled off in a portion close to the winding core of the reel body where the winding pressure becomes relatively large or due to vibration during transportation; if the bonding strength is too strong, an excessive load or impact might be applied when the cover film 5 is peeled off during mounting, thereby adversely affecting the taking-out property of the thermally conductive sheet 10.

### Concave-convex portion

Here, the cover film 5 has a concave-convex portion 20 on which a plurality of protrusions 21 are formed on a pasting surface 5a to be pasted to the surface 4a of the embossed carrier tape 4. By forming the concave-convex portion 20 on the pasting surface of the cover film 5, the electronic component supply body 1 can reduce the contact area between the cover film 5 and the thermally conductive sheet 10 and reduce the risk that the thermally conductive sheet 10 would stick to the cover film 5. In particular, the thermally conductive sheet 10 can be prevented from being sticked to the cover film 5 and taken out along with the cover film 5 when the cover film 5 is peeled off even when the thermally conductive sheet 10 comes into contact with the cover film 5 at a portion near the winding core to which a high winding pressure is applied by winding the electronic component supply body 1 in the form of a reel.

In addition, in the electronic component supply body 1, by forming the concave-convex portion 20 on the pasting surface of the cover film 5, it is possible to suppress variations in the peeling force (sealing strength) generated when the cover film 5 is peeled, to smoothly peel off the cover film, to reduce an impact to the accommodating recess 3, to suppress the displacement and the protrusion of the thermally conductive sheet 10, and to improve the taking-out property in the subsequent pickup process.

It should be noted that a release treatment such as a fluorine treatment is not required since the cover film 5 can be smoothly peeled off from the embossed carrier tape 4. Of course, the cover film 5 may be subjected to a release treatment on the pasting surface in addition to forming the concave-convex portion 20.

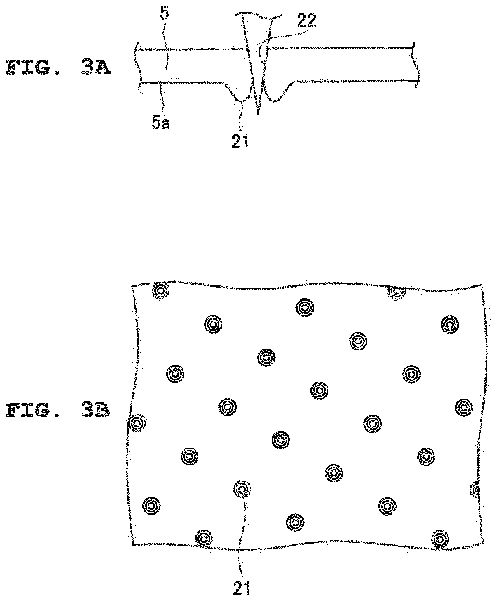

As shown in FIG. 3A, the protrusion 21 are formed by piercing the cover film 5 with a needle to form a through hole 22 so that the periphery of the through hole 22 through which the needle tip penetrates protrudes in a convex shape. For example, the protrusion 21 that protrudes around the perimeter of the through hole 21 has a height of 40 to 60 µm, and the through hole 22 has a diameter of 50 µm. As shown in FIG. 3B, a plurality of the through holes 22 are formed uniformly over the entire surface of the cover film 5. The dimensions of the protrusion 21 and the through hole 22 are examples and various dimensions can be employed in the present technology. However, the lower the height of the protrusion 21 is, the closer the thermally conductive sheet 10 and the cover film 5 are, and therefore the height is preferably 40 µm or more.

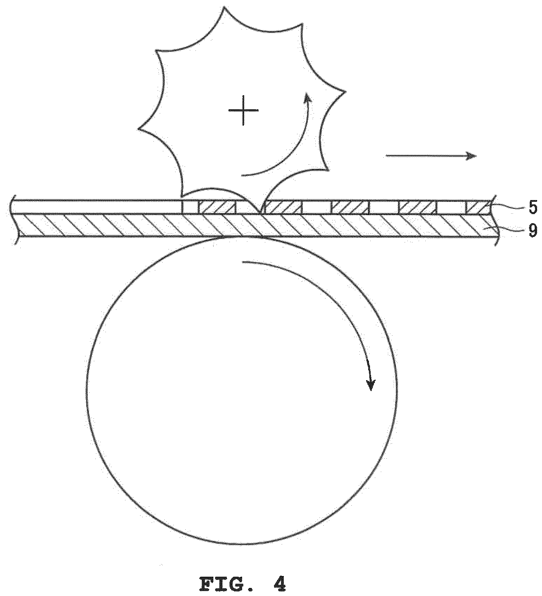

As shown in FIG. 4, for example, the through hole 22 is formed by piercing the cover film 5 with a plurality of sharp members uniformly provided on the surface of the embossing roll of a rotary embossing machine when the cover film 5 supported by a base film 9 is passed through the rotary embossing machine. The protrusion 21 is formed along the pointed end of the sharp member penetrating through the cover film 5. The surface of the cover film 5 on which the protrusions 21 are formed is used as the pasting surface 5a to be pasted to the embossed carrier tape 4.

In place of forming the through holes 22 by the rotary embossing machine, the protrusions 21 may be formed on the pasting surface of the cover film 5 by a thermal pressing, or the concave-convex portion 20 may be formed by other known surface texturing, micromachining, and roughening processes, among others. In addition, in place of forming the plurality of protrusions 21, the concave-convex portion 20 may be formed such that the protruded lines are arranged in parallel in a linear, curved, or zigzag pattern, or in another pattern.

### Electronic component supply reel

In the electronic component supply body 1, after the thermally conductive sheet 10 is accommodated in each of the accommodating recesses 3 of an embossed carrier tape 4, a cover film 5 is bonded to seal the accommodating recesses 3. The cover film 5 and the embossed carrier tape 4 can be bonded by, for example, heat-sealing both side edges of the cover film 5 to the embossed carrier tape 4. Thus, the long-shaped electronic component supply body 1 in which the thermally conductive sheets 10 are accommodated in the accommodating recesses 3 is obtained.

### Reel member

The electronic component supply body 1 is stored and transported as an electronic component supply reel 40 by being wound on a winding core 31 of a reel member 30.

As shown in FIG. 2, for example, the reel member 30 includes the winding core 31 and side plates 32 formed on the side surfaces of the winding core 31. The winding core 31 is formed, for example, in a cylindrical shape around which the electronic component supply body 1 can be wound. The winding core 31 has a shaft hole 33 into which a rotating shaft of a winding device and a feeding device is inserted. The shaft hole 33 has a circular cross section, for example, and a rotary shaft of a winding device or a feeding device is inserted into the shaft hole and driven to rotate the reel member 30. The winding core 31 can be formed of, for example, a variety of plastic materials (for example, polystyrene resins).

The side plates 32 are respectively formed on the side surfaces of the winding core 31. The side plate 32 is in the form of a disk having a sufficiently large diameter with respect to the winding core 31.

The electronic component supply body 1 is formed in a tape shape, and constitutes a wound body in a region formed between the side plates 32 and the winding core 31 by winding the electronic component supply body 1 around the winding core 31 of the reel member 30 such that the cover film 5 is on the outer side.

### Thermally conductive sheet

Next, a configuration example of the thermally conductive sheet 10 will be described. The thermally conductive sheet 10 contains at least a binder resin, carbon fibers, and a thermally conductive filler, and further contains other components, as necessary.

### Binder resin

The binder resin is not particularly limited and can be appropriately selected according to the purpose and may be a thermosetting polymer. Examples of the thermosetting polymer include crosslinked rubber, epoxy resin, polyimide resin, bismaleimide resin, benzocyclobutene resin, phenol resin, unsaturated polyester, diallyl phthalate resin, silicone resin, polyurethane, polyimide silicone, thermosetting polyphenylene ether, and thermosetting modified polyphenylene ether, among others. These may be used alone or in combination of two or more.

Examples of the crosslinked rubber include natural rubber, butadiene rubber, isoprene rubber, nitrile rubber, hydrogenated nitrile rubber, chloroprene rubber, ethylene propylene rubber, chlorinated polyethylene, chlorosulfonated polyethylene, butyl rubber, halogenated butyl rubber, fluororubber, urethane rubber, acrylic rubber, polyisobutylene rubber, and silicone rubber, among others. These may be used alone or in combination of two or more.

Among them, the thermosetting polymer is particularly preferably a silicone resin in view of excellent molding processability and weather resistance, and adhesiveness and followability in electronic components such as semiconductor devices.

The silicone resin is not particularly limited and can be appropriately selected according to the purpose, but preferably contains a main agent of a liquid silicone gel and a curing agent. Examples of such silicone resins include an addition reaction type silicone resin and a thermal vulcanization type millable type silicone resin using a peroxide for vulcanization. Among them, an addition reaction type silicone resin is particularly preferred because adhesion between the heat generating surface of the electronic component and the heat sink surface is required.

The addition reaction type silicone resin is preferably a two-part addition reaction type silicone resin using a polyorganosiloxane having a vinyl group as a main component and a polyorganosiloxane having a Si-H group as a curing agent.

With regard to the combination of the main agent of the liquid silicone gel and the curing agent, the blending ratio of the main agent and the curing agent is not particularly limited and can be appropriately selected according to the purpose.

The content of the binder resin is not particularly limited and can be appropriately selected according to the purpose, but is preferably from 10 to 50 vol%, more preferably from 15 to 40 vol%, and particularly preferably from 20 to 40 vol%.

In this specification, the numerical range indicated by using " value to value" indicates a range including the numerical values before and after" to" as the minimum value and the maximum value, respectively.

### Carbon fiber

The carbon fibers are not particularly limited and can be appropriately selected according to the purpose, and for example, pitch carbon fibers, PAN carbon fibers, carbon fibers obtained by graphitizing PBO fibers, and carbon fibers synthesized by an arc discharge method, a laser evaporation method, a CVD (chemical vapor deposition) method, and a CCVD (catalytic chemical vapor deposition) method may be used. Among them, carbon fibers obtained by graphitizing PBO fibers and pitch-based carbon fibers are particularly preferable from the viewpoint of thermal conductivity.

The carbon fiber is not coated with an insulating material but has electrical conductivity. Further, a part or the whole of the carbon fiber may be treated by surface treatment, if necessary, in order to enhance adhesion. The surface treatment includes, for example, oxidation, nitriding, nitration, sulfonation, or a treatment for attaching or bonding a metal, a metal compound, an organic compound or the like to the surface of a functional group introduced by these treatments or to the surface of the carbon fiber. Examples of the functional group include a hydroxyl group, a carboxyl group, a carbonyl group, a nitro group, and an amino group.

The average fiber length (average long axis length) of the carbon fiber is not particularly limited and can be appropriately selected according to the purpose, but is preferably from 50 to 250 µm, more preferably from 75 to 200 µm, and particularly preferably from 90 to 170 µm. The average fiber diameter (average short axis length) of the carbon fiber is not particularly limited and can be appropriately selected according to the purpose, but is preferably from 4 to 20 µm, and more preferably from 5 to 14 µm.

The aspect ratio (average long axis length / average short axis length) of the carbon fiber is not particularly limited and can be appropriately selected according to the purpose, but is preferably 8 or more, and more preferably 9 to 30. When the aspect ratio is less than 8, the thermal conductivity might decrease since the fiber length (long axis length) of the carbon fiber is short. The average long axis length and the average short axis length of the carbon fiber can be measured by, for example, a microscope or a scanning electron microscope (SEM).

The content of the carbon fiber is not particularly limited and can be appropriately selected according to the purpose, but is preferably from 2 to 40 vol %, more preferably from 3 to 38 vol %, and particularly preferably from 4 to 30 vol %. If the content of the carbon fibers is less than 2 vol%, it may be difficult to obtain a sufficiently low thermal resistance, and if the content exceeds 40 vol%, it may affect the formability of the thermally conductive sheet 10 and the orientation of the carbon fibers.

The mass ratio of the carbon fiber to the binder resin (carbon fiber / binder resin) is less than 1.30, preferably 0.10 or more and less than 1.30, more preferably 0.30 or more and less than 1.30, still more preferably 0.50 or more and less than 1.30, and particularly preferably 0.60 or more and less than 1.20. When the mass ratio of the carbon fiber to the binder resin is 1.30 or more, the insulation of the thermally conductive sheet 10 becomes insufficient. If the thermally conductive sheet 10 does not contain carbon fibers, the thermal characteristics (especially, thermal conductivity) of the thermally conductive sheet 10 become insufficient.

### Thermally conductive filler

The thermally conductive filler is not particularly limited as long as it is a thermally conductive filler other than carbon fiber, and can be appropriately selected according to the purpose, and an inorganic filler may be used, for example.

The shape, material, or average particle size of the inorganic filler is not particularly limited and can be appropriately selected according to the purpose. The shape of the inorganic filler is not particularly limited, can be appropriately selected according to the purpose, and may be spherical, elliptical spherical, massive, granular, flat, or needle-like shape. Among them, the spherical shape and the elliptical shape are preferable from the viewpoint of the fillability, and the spherical shape is particularly preferable. It should be noted that, in this specification, the inorganic filler is different from the carbon fiber.

Examples of the inorganic filler include aluminum nitride (aluminum nitride: AlN), silica, aluminum oxide (alumina), boron nitride, titania, glass, zinc oxide, silicon carbide, silicon, silicon oxide, and metal particles, among others. These may be used alone or in combination of two or more. Among them, aluminum oxide, boron nitride, aluminum nitride, zinc oxide, and silica are preferable, and aluminum oxide, aluminum nitride, and zinc oxide are particularly preferable from the viewpoint of thermal conductivity.

The inorganic filler may be subjected to surface treatment. When the inorganic filler is surface treated with a coupling agent, the dispersibility of the inorganic filler is improved and the flexibility of the thermally conductive sheet 10 is improved.

The average particle size of the inorganic filler is not particularly limited, and can be appropriately selected according to the purpose. When the inorganic filler is alumina, the average particle diameter thereof is preferably from 1 to 10 µm, more preferably from 1 to 5 µm, and particularly preferably from 3 to 5 µm. When the average particle diameter is less than 1 µm, the viscosity may be increased and mixing become difficult, and when the average particle diameter exceeds 10 µm, there is a possibility that the thermal resistance of the thermally conductive sheet 10 is increased.

When the inorganic filler is aluminum nitride, the average particle size thereof is preferably from 0.3 to 6.0 µm, more preferably from 0.3 to 2.0 µm, and particularly preferably from 0.5 to 1.5 µm. When the average particle diameter is less than 0.3 µm, the viscosity may be increased and the mixing may become difficult, and when the average particle diameter exceeds 6.0 µm, the thermal resistance of the thermally conductive sheet 10 may be increased.

The average particle size of the inorganic filler can be measured by, for example, a particle size distribution meter or a scanning electron microscope (SEM).

The content of the thermally conductive filler ranges from 48 to 70 vol%, preferably from 50 to 69 vol%. When the content of the thermally conductive filler is less than 48 vol% or more than 70 vol%, it becomes difficult to achieve both electrical insulation and high thermal conductivity simultaneously. In addition, when the content of the thermally conductive filler is less than 48 vol% or more than 70 vol%, it becomes difficult to produce the thermally conductive sheet 10.

### Other contents

Other contents are not particularly limited and can be appropriately selected according to the purpose, and include, for example, thixotropy-imparting agents, dispersing agents, curing accelerators, retarders, slight tackifiers, plasticizers, flame retardants, antioxidants, stabilizers, and colorants, among others.

The average thickness of the thermally conductive sheet 10 is not particularly limited and can be selected as desired, but is preferably from 0.05 to 5.00 mm, more preferably from 0.07 to 4.00 mm, and particularly preferably from 0.10 to 3.00 mm.

The surface of the thermally conductive sheet 10 is preferably covered with exudation components exuded from the thermally conductive sheet 10 so as to follow the convex shape of the projecting carbon fibers. For example, such a surface of the thermally conductive sheet 10 can be formed by a surface coating step described later.

In order to prevent short-circuiting of electronic circuits around semiconductor elements to be used, the volume resistance value of the thermally conductive sheet 10 at an applied voltage of 1,000 V is preferably 1.0 * 10⁸ Ω *cm or more, more preferably 1.0 * 10¹⁰ Ω *cm or more. The volume resistance value is measured according to, for example, JIS K-6911.

The upper limit value of the volume resistivity is not particularly limited, and can be appropriately selected according to the purpose, for example, the volume resistivity is 1.0 * 10¹⁸ Ω *cm or less.

In view of the adhesiveness of the thermally conductive sheet 10 to the electronic components and the heat sink, the compression ratio at a load of 0.5 kgf / cm² is preferably 3% or more, and more preferably 15% or more. The upper limit value of the compressibility of the thermally conductive sheet 10 is not particularly limited and can be appropriately selected according to the purpose, but the compressibility of the thermally conductive sheet 10 is preferably 30% or less.

In the thermally conductive sheet 10, carbon fibers are oriented in the thickness direction of the thermally conductive sheet 10. By this orientation, along with the aforementioned specific mass ratio of the carbon fiber to the binder resin and the specific content of the aforementioned heat conductive filler, the thermally conductive sheet 10 can have a high heat conductivity and excellent insulating properties.

### Method for manufacturing thermally conductive sheet

The method for manufacturing the thermally conductive sheet 10 includes at least a molded body forming step and a molded body sheet forming step, preferably a surface coating step, and optionally other steps.

### Molded body manufacturing process

The molded body forming step is a step of forming the thermally conductive resin composition containing the binder resin, the carbon fiber, and the thermally conductive filler into a predetermined shape and curing the resin composition to obtain a molded body of the thermally conductive resin composition. Examples of the molding method of the thermally conductive resin composition include an extrusion molding method and a metal molding method. Further, the curing of the thermally conductive resin composition is preferably thermosetting.

The size and shape of the molded body (block-shaped molded body) can be determined according to the required size of the thermally conductive sheet 10. For example, a rectangular parallelepiped having a vertical cross section of 0.5 to 15 cm and a horizontal cross section of 0.5 to 15 cm can be exemplified.

### Molded body sheet forming step

The molded body sheet forming step is a step for obtaining a molded body sheet by cutting the molded body into a sheet shape by, for example, a slicing device. It should be noted that, in the case of forming a molded body in which the carbon fibers are oriented along the extrusion direction by the extrusion molding method described above, the molded body is preferably cut in the direction perpendicular to the extrusion direction.

From the surface of the molded sheet, carbon fibers protrude. It is considered that this is because, when the molded body is cut into a sheet shape by a slicing device or the like, the cured component of the binder resin is pulled by a cutting member of the slicing device due to the difference in hardness between the cured component of the binder resin and the carbon fiber, and the cured component of the binder resin is removed from the surface of the carbon fiber on the surface of the molded body sheet.

The average thickness of the molded body sheet is not particularly limited and can be appropriately selected according to the purpose, but is preferably from 0.06 to 5.01 mm, more preferably from 0.08 to 4.01 mm, and particularly preferably from 0.11 to 3.01 mm.

### Surface coating step

The surface coating step is a step of covering the surface of the molded body sheet with exudation components exuded from the molded body sheet so as to follow the projecting shape of the projecting carbon fibers, and may be performed, for example, by press processing or molded body sheet leaving processing. Here, the term "exudation components" refers to components included in the thermally conductive resin composition but not contributing to curing, such as non-curing components and uncured components of the binder resin.

By exuding the exudate component from the molded body sheet and coating the surface with the exudate component, the thermally conductive sheet 10 can improve the followability and adhesion to the surface of the electronic component and the heat spreader, and can reduce the thermal resistance. Further, when thickness of the coating by the exudation component is at a level enough to reflect the shape of the carbon fibers on the surface of the thermally conductive sheet 10, the increase in thermal resistance can be avoided.

Further, the thermally conductive sheet 10 has a tackiness (slight adhesiveness) by being covered with the exudate component, and can be stably held when it is pasted to an electronic component or a heat sink, and can recover the tackiness by being covered with the exudate component again even if it is repeatedly pasted.

The thermally conductive sheet 10 is compressed in the thickness direction by pressing the molded body sheet, so that the amount of contact between the carbon fibers and the thermally conductive fillers can be increased, thereby reducing the thermal resistance.

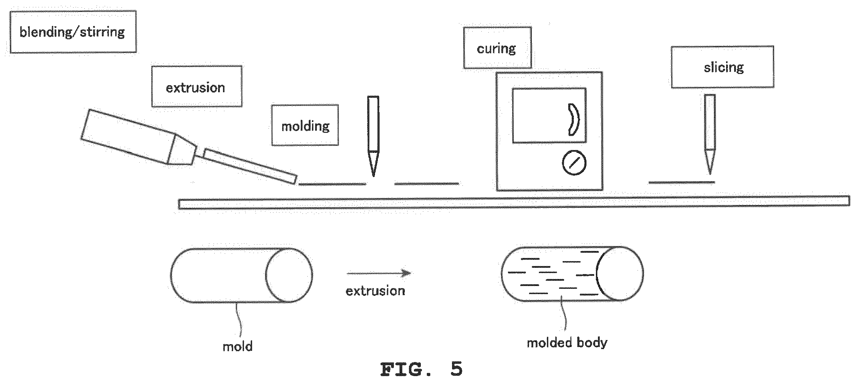

FIG. 5 is a schematic view showing an example of a manufacturing process of the thermally conductive sheet 10. As shown in FIG. 5, the thermally conductive sheet 10 is manufactured through a series of steps such as extrusion, molding, curing, and cutting (slicing). First, a binder resin, a carbon fiber, and a thermally conductive filler are mixed and stirred to prepare a thermally conductive resin composition. Next, the prepared thermally conductive resin composition is extruded and the carbon fibers blended in the thermally conductive resin composition are oriented in the extrusion direction by passing through a plurality of slits to obtain a molded body. Next, after the obtained molded body is cured, the cured molded body is cut to a predetermined thickness by an ultrasonic cutter in a direction perpendicular to the extrusion direction, thereby producing a molded body sheet (thermally conductive sheet).

The thermally conductive sheet 10 is accommodated in the accommodating recess 3 of the embossed carrier tape 4 and then sealed by the cover film 5 to be accommodated in the electronic component supply body 1. Further, as described above, the electronic component supply body 1 containing the thermally conductive sheet 10 is wound in a reel shape, and is transported and stored as the electronic component supply reel 40. In use, after the electronic component supply body 1 is unwound from the reel member 30 and the cover film 5 is peeled off, the thermally conductive sheet 10 is picked up from the accommodating recess 3 by a vacuum nozzle or the like.

At this time, since the concave-convex portion 20 is formed on the pasting surface 5a of the cover film 5 in the electronic component supply body 1, even when the thermally conductive sheet 10 comes into contact with the cover film 5, the thermally conductive sheet 10 can be prevented from being taken out along with the cover film 5 when the cover film 5 is peeled off due to the close contact between the cover film 5 and the thermally conductive sheet 10.

In addition, in the electronic component supply body 1, by forming the concave-convex portion 20 on the pasting surface of the cover film 5, it is possible to suppress variations in the peeling force (sealing strength) generated when the cover film 5 is peeled, to smoothly peel off the cover film, to reduce an impact to the accommodating recess 3, to suppress the displacement and the protrusion of the thermally conductive sheet 10, and to improve the taking-out property in the subsequent pickup process.

### Semiconductor device

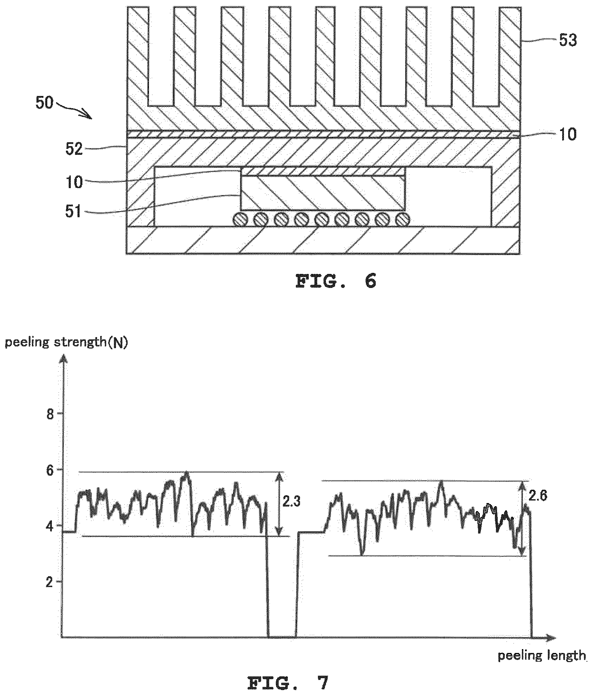

Such a thermally conductive sheet 10 can be applied to a semiconductor device 50, for example, as shown in FIG. 6. The semiconductor device 50 has at least an electronic component 51, a heat spreader 52, and the thermally conductive sheet 10, and the thermally conductive sheet 10 is held between the heat spreader 52 and the electronic component 51.

The electronic component 51 is not particularly limited, and can be appropriately selected according to the purpose, and may be a CPU, an MPU, a graphic computing element, and the like. The heat spreader 52 is not particularly limited as long as it is a member that radiates heat generated by the electronic component 51, and can be appropriately selected according to the purpose. The thermally conductive sheet 10 is sandwiched between the heat spreader 52 and the electronic component 51. The thermally conductive sheet 10 sandwiched between the heat spreader 52 and the heat sink 53 constitutes, together with the heat spreader 52, a heat radiation member for radiating the heat of the electronic component 51.

### Examples

Next, examples of the present technology will be described. An electronic component supply body in which an accommodating recess of an embossed carrier tape is sealed by a cover film provided with the concave-convex portion on the pasting surface as an example, and an electronic component supply body in which an accommodating recess of the embossed carrier tape is sealed by a cover film having no concave-convex portion on the pasting surface as a comparative example are prepared, and peeling strengths of these are measured and compared.

### Embossed carrier tape

As the embossed carrier tape used for the example and comparative example, an embossed carrier tape manufactured by Advantech Japan (product number of GS28419, tape width of 24 mm, accommodating recess pitch of 12 mm, tape material of PS antistatic material, accommodating recess thickness t of 0.3 mm) was used.

### Cover film: Example

As the cover film used in the example, a cover tape manufactured by Nippo (product number of 600600410 ALS-S 21.0X720-3) was used, and this cover film was passed through a rotary embossing machine in a state of being supported by a base film, and the cover film was pierced by a plurality of sharp members uniformly provided on the surface of the embossing roll of the embossing machine, thereby forming protrusions protruding along the sharp end of the sharp member penetrating through the cover film over the entire surface of the film.

### Cover Tape / Comparative example

As the cover film used for the comparative example, a cover tape manufactured by NIPPO (product number of 600600410 ALS-S 21.0X720-3) was used. In the comparative example, the cover film was not particularly processed.

### Cover film sealing condition

The cover films according to the example and the comparative example were bonded to the embossed carrier tape by heat sealing to obtain electronic component supply bodies. The sealing conditions were sealing-set temperature of 184 ° C, sealing time of 0.4 seconds, and feed pitch of 12 mm.

### Peeling test

The cover films of the electronic component supply bodies of the example and comparative example were peeled off from the embossed carrier tape, and the peeling strength (strength of the heat-sealed part) was measured. In the peeling test, a peeling strength tester manufactured by Palmec (product name: PFT-50S) was used as a pealing strength measuring device. The peeling test conditions were peeling speed of 120 mm / min and peeling angle of 170 °.

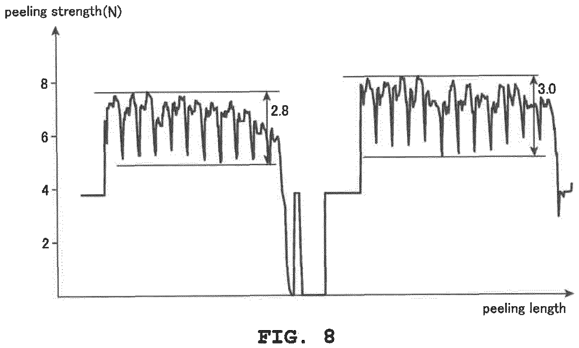

FIG. 7 shows the result of the peeling test of the electronic component supply body according to the example, and FIG. 8 shows the result of the peeling test of the electronic component supply body according to the comparative example. In the peeling test, a group of waveforms showing the peeling strength (N) with respect to the peeling length of the cover film appears periodically because two samples are prepared in both the example and comparative example and the peeling strength (N) decreases to zero when the samples are replaced.

FIG. 7 is a graph showing the peeling strength (N) with respect to the peeling length of a cover film of an electronic component supply body according to the example. As shown in FIG. 7, in the electronic component supply body according to the example, the variation width of the waveform group indicating the peeling strength (N) of the cover film was 2.3 (N) and 2.6 (N), and the average was 2.45 (N).

FIG. 8 is a graph showing the peeling strength (N) with respect to the peeling length of the cover film of the electronic component supply body according to a comparative example. As shown in FIG. 8, in the electronic component supply body according to the comparative example, the variation width of the waveform group showing the peeling strength (N) of the cover film was 2.8 (N) and 3.0 (N), and the average was 2.9 (N).

It is understood that in the example, the variation width of the peeling strength of the cover film is smaller (2.5 N or less) than in the comparative example, and the cover film can be peeled smoothly. It is presumed that this is because the concave-convex processing reduces the contact area of the cover film to the embossed carrier tape so that the heat-sealed cover film can be smoothly peeled off, thereby suppressing the variation width of the peeling strength.

Therefore, in the electronic component supply body according to the example, the sealing strength can be adjusted more easily than in the comparative example, and the thermally conductive sheet can be taken out more easily. If the variation width of the peeling strength of the cover film is large, the impact to the embossed carrier tape and the thermally conductive sheet accommodated in the accommodating portion is also large at the time of peeling, so that there is a possibility that the thermally conductive sheet is shifted in the accommodating portion or adheres to the side wall of the accommodating portion or the cover film. If the peeling strength itself is reduced in order to reduce the variation width of the peeling strength, the cover film might be peeled off during transportation or storage. In particular, when the cover film is wound around a reel member, the cover film is likely to be peeled off due to high winding pressure at a portion near the winding core.

However, according to the example, by keeping the peeling strength of the cover film high, the resistance against the winding pressure when the electronic component supply body is wound in the form of a reel can be secured, and at the time of peeling, the variation width of the peeling strength can be suppressed to improve the taking-out property of the thermally conductive sheet.

### DESCRIPTION OF REFERENCE CHARACTERS

1 electronic component supply body, 2 electronic component, 3 accommodating recess, 3a bottom surface, 3b side surface, 4 embossed carrier tape, 4 surface, 5 cover film, 5a pasting surface, 6 feed hole, 9 base film, 10 thermally conductive sheet, 20 concave-convex portion, 21 protrusion, 22 through hole, 30 reel member, 31 winding core, 32 side plate, 33 shaft hole, 40 electronic component supply reel, 50 semiconductor device, 51 electronic component, 52 heat spreader, 53 heat sink

## Claims

1. An electronic component supply body (1) comprising:
an embossed carrier tape (4) which is formed in a long shape and has a plurality of accommodating recesses (3) on the surface thereof (3a) respectively accommodating one electronic component (2); and
a cover film (5) which is formed in a long shape and is laminated on the surface of the embossed carrier tape (4) to seal the accommodating recess (3),
**characterized in that** a pasting surface (5a) of the cover film (5) to be pasted to the embossed carrier tape (4) is formed with a concave-convex portion (20) on which a plurality of protrusions (21) are formed such that variations in the peeling force generated when the cover film (5) is peeled are suppressed,
wherein the protrusions (21) are formed by piercing the cover film (5) with a needle to form a through hole (22) so that the periphery of the through hole (22) through which the needle tip penetrates protrudes in a convex shape, and
wherein a plurality of the through holes (22) are formed uniformly over the entire surface of the cover film (5).

2. The electronic component supply body (1) according to claim 1, **characterized in that** the electronic component (2) is a thermally conductive sheet (10).

3. The electronic component supply body (1) according to claim 1 or 2, **characterized in that** the variation width of the peeling strength of the cover film (5) with respect to the embossed carrier tape (4) is less than 2.5 (N).

4. An electronic component supply reel comprising:
an electronic component supply body (1) according to any one of claims 1 to 3; and
a reel member (30) around which the electronic component supply body (1) is wound.

## Patentansprüche

1. Elektronikkomponentenzuführkörper (1) umfassend:
ein geprägtes Trägerband (4), das in einer langen Form gebildet ist und auf seiner Oberfläche (3a) eine Mehrzahl von Aufnahmevertiefungen (3) zur Aufnahme jeweils einer Elektronikkomponente (2) aufweist; und
einen Abdeckstreifen (5), der in einer langen Form gebildet ist und auf die Oberfläche des geprägten Trägerbands (4) laminiert ist, um die Aufnahmevertiefung (3) zu verschließen,
**dadurch gekennzeichnet, dass** eine Haftfläche (5a) des Abdeckstreifens (5), die an das geprägte Trägerband (4) anzuhaften ist, mit einem konkav-konvexen Bereich (20) gebildet ist, auf dem eine Mehrzahl von Ausbuchtungen (21) so ausgebildet sind, dass Schwankungen in der Schälfestigkeit, die erzeugt werden, wenn der Abdeckstreifens (5) abgezogen wird, unterdrückt sind,
wobei die Ausbuchtungen (21) durch das Durchstechen des Abdeckstreifens (5) mit einer Nadel gebildet sind, um ein Durchgangsloch (22) zu bilden, so dass der Rand des Durchgangslochs (22), durch das die Nadelspitze hindurchdringt, in einer konvexen Form hervorsteht, und
wobei eine Mehrzahl der Durchgangslöcher (22) gleichmäßig über die gesamte Oberfläche des Abdeckstreifens (5) gebildet sind.

2. Elektronikkomponentenzuführkörper (1) nach Anspruch 1, **dadurch gekennzeichnet, dass** die Elektronikkomponente (2) eine wärmeleitende Folie (10) ist.

3. Elektronikkomponentenzuführkörper (1) nach Anspruch 1 oder 2, **dadurch gekennzeichnet, dass** die Schwankungsbreite der Schälfestigkeit des Abdeckstreifens (5) gegenüber dem geprägten Trägerband (4) weniger als 2,5 (N) beträgt.

4. Elektronikkomponentenzuführrolle, umfassend:
einen Elektronikkomponentenzuführkörper (1) nach einem der Ansprüche 1 bis 3; und
ein Rollenelement (30), um das der Elektronikkomponentenzuführkörper (1) gewickelt ist.

## Revendications

1. Corps d'alimentation en composants électroniques (1) comprenant :
un ruban de support gaufré (4) qui est formé en une forme longue et a une pluralité de retraits d'hébergement (3) sur la surface de celui-ci (3a) hébergeant respectivement un composant électronique (2) ; et
un film de recouvrement (5) qui est formé en une forme longue et est stratifié sur la surface du ruban de support gaufré (4) pour sceller le retrait d'hébergement (3),
**caractérisé en ce qu'**une surface de collage (5a) du film de recouvrement (5) devant être collée au ruban de support gaufré (4) est formée d'une portion concave-convexe (20) sur laquelle une pluralité de saillies (21) sont formées de sorte que des variations de la force de pelage générée lorsque le film de recouvrement (5) est pelé sont supprimées,
dans lequel les saillies (21) sont formées en perçant le film de recouvrement (5) avec une aiguille pour former un orifice traversant (22) de sorte que la périphérie de l'orifice traversant (22) à travers laquelle la pointe d'aiguille pénètre fait saillie en une forme convexe, et
dans lequel une pluralité des orifices traversants (22) sont formés uniformément sur la surface entière du film de recouvrement (5).

2. Corps d'alimentation en composants électroniques (1) selon la revendication 1, **caractérisé en ce que** le composant électronique (2) est une feuille thermiquement conductrice (10).

3. Corps d'alimentation en composants électroniques (1) selon la revendication 1 ou 2, **caractérisé en ce que** la largeur de variation de la résistance au pelage du film de recouvrement (5) par rapport au ruban de support gaufré (4) est inférieure à 2,5 (N).

4. Bobine d'alimentation en composants électroniques comprenant :
un corps d'alimentation en composants électroniques (1) selon l'une quelconque des revendications 1 à 3, ; et
un élément de bobine (30) autour duquel le corps d'alimentation en composants électroniques (1) est enroulé.
